Europäisches Patentamt

European Patent Office

Office européen des brevets

(19)

(11) Numéro de publication: **0 099 787**
**A1**

(12) **DEMANDE DE BREVET EUROPEEN**

(21) Numéro de dépôt: 83401331.0

(22) Date de dépôt: 28.06.83

(51) Int. Cl.³: **H 01 L 29/08**
**H 01 L 21/265**

(30) Priorité: 01.07.82 FR 8211571

(43) Date de publication de la demande:
01.02.84 Bulletin 84/5

(84) Etats contractants désignés:
BE CH DE GB IT LI NL

(71) Demandeur: COMMISSARIAT A L'ENERGIE ATOMIQUE
Etablissement de Caractère Scientifique Technique et
Industriel
31/33, rue de la Fédération
F-75015 Paris(FR)

(72) Inventeur: Jeuch, Pierre
49, Avenue Louis Armand
F-38170 Seyssins(FR)

(72) Inventeur: Bonnet, Thierry
18, Quai Victor Hugo
F-94500 Champigny(FR)

(74) Mandataire: Mongrédien, André et al,
c/o BREVATOME 25, rue de Ponthieu
F-75008 Paris(FR)

(54) **Procédé d'optimisation du dopage dans un transistor MOS.**

(57) L'invention concerne un procédé d'optimisation du
dopage dans un transistor MOS, ce transistor comprenant un
canal défini, dans un substrat semiconducteur dopé (2), par
une implantation d'ions appartenant à un premier type
d'ions donnant un dopage du même type que celui du
substrat (2), une source (4) et un drain (6) définis, dans ledit
substrat, par une implantation d'ions appartenant à un
deuxième type d'ions donnant un dopage différent de celui
du substrat (2), et une grille (10) caractérisé en ce que l'on
réalise, sous la source (4) et le drain (6) du transistor au
moins une implantation d'ions appartenant au deuxième
type d'ions définissant dans le substrat deux régions latérales
(16, 18), cette implantation étant faite à une dose telle qu'elle
compense le dopage du substrat (2) sans en inverser le type,
la grille (10) du transistor servant de masque à cette
implantation, et en ce que l'on soumet le substrat (2) à un
recuit.

FIG. 1

EP 0 099 787 A1

La présente invention a pour objet un procédé d'optimisation du dopage dans un transistor MOS (métal-oxyde-semiconducteur).

De plus en plus, on cherche à diminuer, par tous les moyens possibles, les dimensions des composants élémentaires des circuits intégrés et en particulier ceux des circuits comportant des transistors MOS. Pour augmenter la densité d'intégration de ces circuits, on cherche en particulier à diminuer la longueur du canal des transistors MOS, c'est-à-dire, la distance séparant la source et le drain de ces transistors.

Afin d'éviter le perçage, c'est-à-dire une liaison entre la zone de charge d'espace de la source et la zone de charge d'espace du drain de ces transistors MOS, lors de la diminution de la longueur de leurs canaux, on implante, sous ces derniers, des ions donnant un dopage du même type que celui du substrat dans lequel on réalise le transistor ; plus on cherche à diminuer la longueur du canal d'un transistor MOS, plus la dose d'ions implantés sous le canal doit être élevée.

Malheureusement, l'augmentation d'un tel dopage conduit à une augmentation des capacités parasites entre la source, le drain et le substrat des transistors, du fait de la diminution de la largeur des zones de charge d'espace affectant les caractéristiques électriques de ces derniers.

Afin d'améliorer les caractéristiques électriques des transistors MOS, l'une des méthodes possible consisterait à augmenter le dopage du substrat dans la région de celui-ci située uniquement sous la grille du transistor, de façon à ne pas augmenter le dopage dans les régions du substrat situées en dessous de la source et du drain de ce transistor.

B 7470-3 LC

La présente invention a justement pour objet un procédé d'optimisation du dopage dans un transistor MOS permettant d'obtenir un tel profil de dopage. Selon l'invention, ce profil de dopage est obtenu en compensant, au niveau de la source et du drain du transistor MOS, le dopage du substrat sous le canal de ce transistor.

De façon plus précise, l'invention a pour objet un procédé d'optimisation du dopage dans un transistor MOS, ce transistor étant réalisé sur un substrat en silicium dopé, ayant un profil de dopage défini par une implantation d'ions appartenant à un premier type d'ions donnant un dopage du même type que celui du substrat, une source et un drain définis, dans ledit substrat, par une implantation d'ions appartenant à un deuxième type d'ions donnant un dopage différent de celui du substrat, et une grille, caractérisé en ce que l'on réalise, sous la source et le drain du transistor une ou plusieurs implantations d'ions appartenant au deuxième type d'ions, à des doses et des énergies telles qu'elles compensent le dopage du substrat sans en inverser le type, la grille du transistor servant de masque à cette implantation, et en ce que l'on soumet le substrat à un recuit.

Le fait d'utiliser la grille du transistor comme masque à l'implantation d'ions sous la source et le drain du transistor permet d'obtenir des régions de compensation auto-alignées par rapport à la grille du transistor.

Selon un mode préféré de mise en oeuvre du procédé selon l'invention, on soumet le substrat à un recuit transitoire, ce recuit étant effectué soit au moyen d'un faisceau laser, soit au moyen d'un faisceau d'électrons, soit encore au moyen d'un chauffage radiatif par lampes ou résistances chauffantes.

L'utilisation d'un recuit transitoire par rapport à l'utilisation d'un recuit classique au four permet d'éviter la diffusion des ions implantés sous la source et le drain de transistor. Ceci permet donc d'obtenir une compensation du dopage beaucoup plus précise.

Selon l'invention, le substrat étant réalisé en silicium de type P, les ions appartenant au premier type d'ions sont des ions de bore et les ions appartenant au deuxième type d'ions sont des ions de phosphore ou d'arsenic.

De même, selon l'invention, le substrat étant réalisé en silicium de type N, les ions appartenant au premier type d'ions sont des ions de phosphore ou d'arsenic et les ions appartenant au deuxième type d'ions sont des ions de bore.

D'autres caractéristiques et avantages de l'invention ressortiront mieux de la description qui va suivre, donnée à titre explicatif mais nullement limitatif, en référence aux figures annexées, sur lesquelles :

- la figure 1 représente, schématiquement, en coupe transversale, la structure d'un transistor MOS, dans lequel on a optimisé le dopage selon l'invention, et

- la figure 2 représente des courbes donnant la quantité d'ions implantés, exprimée en ions par $cm^3$, pour les différents dopages du substrat, effectués lors de la fabrication d'un transistor MOS à canal N, en fonction de la profondeur (P) de pénétration des ions dans le substrat exprimée en micron, ces courbes illustrant la compensation selon l'invention du dopage du substrat sous le canal du transistor.

Afin de simplifier la description qui va suivre, on se place dans le cas d'un transistor MOS à canal N, réalisé sur un substrat de type P. Bien entendu, ce procédé est applicable au cas d'un transistor à canal P sur un substrat de type N, les implantations d'ions de bore étant dans ce cas remplacées par des implantations d'ions de phosphore ou d'arsenic et inversement.

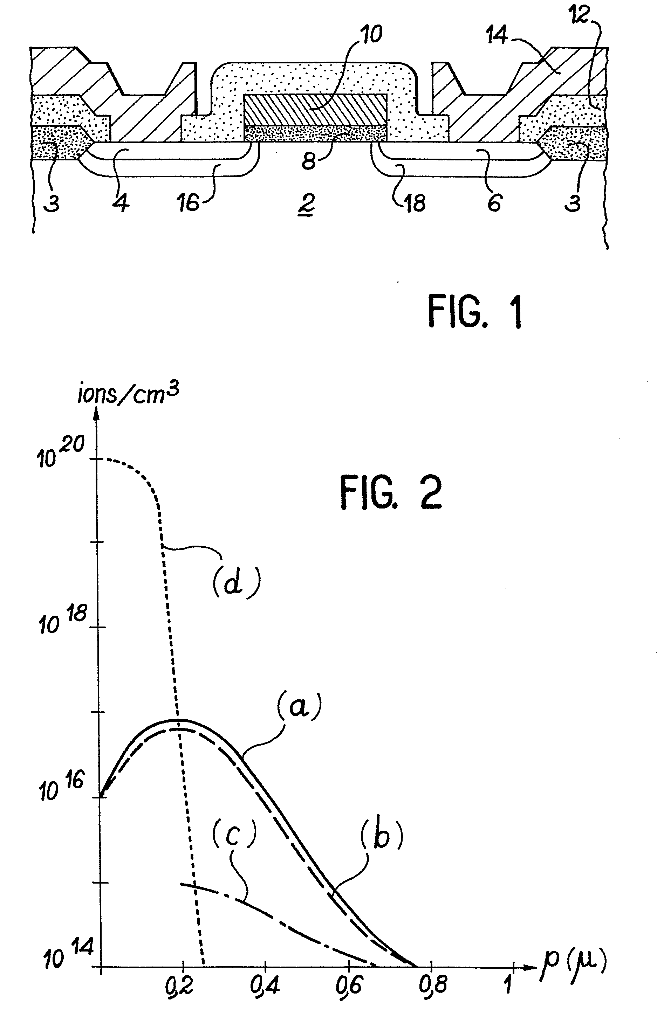

Sur la figure 1, on a représenté, en coupe transversale, la structure d'un transistor MOS. Ce transistor MOS, réalisé sur un substrat semiconducteur dopé 2, dans une ouverture de l'oxyde de champ 3, comprend, de façon classique, deux régions latérales 4 et 6, correspondant respectivement à la source et au drain de ce transistor, et une couche d'oxyde 8, recouvrant la région centrale du substrat 2, surmontée d'une couche conductrice 10. La couche conductrice 10 correspond à la grille du transistor et la couche d'oxyde 8 à l'oxyde de grille. L'ensemble du transistor MOS est recouvert d'une couche d'oxyde 12, gravée de façon à définir les trous de contacts électriques du transistor, cette couche d'oxyde 12 étant elle-même recouverte d'une couche conductrice 14, gravée de façon à définir les connexions électriques.

De façon classique, la fabrication de ce transistor MOS se fait, tout d'abord, en réalisant l'oxyde de champ 3 et l'oxyde de grille 8, puis en implantant des ions de bore permettant de définir le dopage sous le canal du transistor. Cette implantation d'ions est par exemple effectuée à une dose de $10^{12}$ atomes/cm$^2$ et à une énergie de 50 KeV, puis à une dose de $4.10^{11}$ atomes/cm$^2$ et à une énergie de 140 keV.

Après ce dopage du substrat 2, on réalise la grille 10 du transistor, généralement dans une couche de silicium polycristallin dopé, puis la source 4 et le drain 6 de ce transistor. La source et le drain de ce transistor sont obtenus en implantant des ions de phosphore ou d'arsenic, cette implantation étant réalisée en utilisant la grille du transistor comme masque à ladite implantation. Cette implantation est par exemple réalisée pour des ions d'arsenic à une dose de $5.10^{15}$ atomes/$cm^2$ et à une énergie de 100 keV.

Ensuite, on dépose sur l'ensemble du substrat 2, la couche d'oxyde 12 que l'on grave de façon à réaliser les trous de contacts électriques du transistor, puis l'on recouvre cette couche d'oxyde 12 d'une couche conductrice 14, généralement en aluminium, que l'on grave de façon appropriée pour réaliser les connexions électriques du transistor.

Selon l'invention, afin de compenser le dopage du substrat sous le canal du transistor MOS, on réalise, sous la source 4 et sous le drain 6 du transistor, une ou plusieurs implantations d'ions de phosphore ou d'arsenic suivi éventuellement d'une implantation de bore, le nombre d'implantations étant fonction de la quantité et du profil d'ions de bore servant à la définition du dopage sous le canal ainsi que du profil de ce dopage. Cette implantation qui est effectuée avant de déposer la couche d'oxyde 12 sur le substrat permet d'obtenir deux régions latérales 16 et 18 situées respectivement sous la source 4 et sous le drain 6 du transistor.

Dans le cas d'une double implantation de bore définissant le dopage sous le canal, prise en exemple précédemment, on pourra effectuer, pour compenser ce dopage, une implantation de phosphore avec une dose de $10^{12}$ atomes/$cm^2$ à une énergie de 120 keV, suivie d'une deuxième implantation de phosphore à une dose de $4.10^{11}$ atomes/$cm^2$ à une énergie

B 7470-3 LC

de 280 keV, puis d'une implantation de bore avec une dose de $3.10^{11}$ atomes/cm$^2$ à une énergie de 80 keV.

Afin d'obtenir les deux régions 16 et 18 auto-alignées par rapport à la grille 10 du transistor, cette implantation sera effectuée en utilisant la grille du transistor comme masque à ladite implantation. On conservera la résine ayant servi à la définition de la grille du transistor, lors de ces implantations, pour améliorer l'effet de masquage de la grille. Après élimination de la résine, et afin de réarranger le réseau cristallin perturbé lors de cette implantation, on soumet le substrat 2 à un recuit. De préférence, on utilise un recuit transitoire permettant d'éviter ou de minimiser la diffusion des ions implantés sous la source et le drain du transistor. Ce recuit peut être réalisé soit au moyen d'un faisceau laser, soit au moyen d'un faisceau d'électrons, ou au moyen d'un chauffage radiatif par lampes ou résistances chauffantes.

A titre d'exemple, on a représenté sur la figure 2, des courbes donnant la quantité d'ions implantés par cm$^3$, pour les différents dopages, effectués lors de la fabrication du transistor MOS, en fonction de la profondeur P de pénétration des ions dans le substrat. Ces courbes, ou profils de dopage, sont donnés dans le cas d'un substrat en silicium de type P, c'est-à-dire dans le cas d'un transistor MOS à canal N.

Le profil de dopage a correspond à l'implantation définissant le canal du transistor, cette implantation étant faite, dans le présent exemple, avec des ions de bore. Le profil de dopage b correspond à l'implantation permettant de compenser la précédente implantation, conformément à l'invention. Cette implantation est réalisée, dans le présent exemple, avec des ions de phosphore. Le profil de dopage c correspond à la résultante de la courbe a et de la courbe b, c'est-à-dire au profil du dopage résultant des deux précédentes implantations. Enfin, le profil de dopage d correspond à l'implantation définissant la source et le drain du transistor, cette implantation étant réalisée dans le présent exemple avec des ions de phosphore.

Le procédé de dopage, selon l'invention, de mise en oeuvre facile, permet de diminuer les capacités parasites entre la source, le drain et le substrat du transistor.

REVENDICATIONS

1. Procédé d'optimisation du dopage dans un transistor MOS, ce transistor étant réalisé sur un substrat en silicium dopé (2), ayant un profil de dopage défini par une implantation d'ions appartenant à un premier type d'ions donnant un dopage du même type que celui du substrat (2), une source (4) et un drain (6) définis, dans ledit substrat, par une implantation d'ions appartenant à un deuxième type d'ions donnant un dopage différent de celui du substrat (2), et une grille (10), caractérisé en ce que l'on réalise, sous la source (4) et le drain (6) du transistor une ou plusieurs implantations d'ions appartenant au deuxième type d'ions, à des doses et des énergies telles qu'elles compensent le dopage du substrat (2) sans en inverser le type, la grille (10) du transistor servant de masque à ces implantations, et en ce que l'on soumet le substrat (2) à un recuit.

2. Procédé selon la revendication 1, caractérisé en ce que le recuit est un recuit transitoire.

3. Procédé selon la revendication 2, caractérisé en ce que le recuit est effectué au moyen d'un faisceau laser.

4. Procédé selon la revendication 2, caractérisé en ce que le recuit est effectué au moyen d'un faisceau d'électrons.

5. Procédé selon la revendication 2, caractérisé en ce que le recuit est effectué au moyen d'un chauffage radiatif par lampes ou résistances chauffantes.

6. Procédé selon l'une quelconque des revendications 1 à 5, caractérisé en ce que le substrat (2) étant réalisé en silicium de type P, les ions appartenant au premier type d'ions sont des ions de bore et les ions appartenant au deuxième type d'ions sont des ions de phosphore ou d'arsenic.

7. Procédé selon l'une quelconque des revendications 1 à 5, caractérisé en ce que, le substrat (2) étant réalisé en silicium de type N, les ions appartenant au premier type d'ions sont des ions de phosphore ou d'arsenic et les ions appartenant au deuxième type sont des ions de bore.

B 7470-3 LC

0099787

1/1

FIG. 1

FIG. 2

Office européen
des brevets

**RAPPORT DE RECHERCHE EUROPEENNE**

Numéro de la demande

EP 83 40 1331

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | IBM TECHNICAL DISCLOSURE BULLETIN, vol. 17, no. 4, septembre 1974, pages 1208-1209, New York, USA D.R. YOUNG: "Metal-oxide semiconductor field-effect transistor structure" * Page 1209, paragraphe 2 * | 1 | H 01 L 29/08 H 01 L 21/265 |
| | --- | | |
| A | FR-A-2 337 428 (I.B.M.) * Revendications 1,3-5 * | 1,6 | |
| | --- | | |
| A | IEEE JOURNAL OF SOLID-STATE CIRCUITS, vol. SC-14, no. 3, juin 1979, pages 651-653, New York, USA J. PEREIRA DE SOUZA et al.: "A simplified self-aligned Al-gate MOS technology for high performance depletion-logic circuits" | | DOMAINES TECHNIQUES RECHERCHES (Int. Cl. ³) |
| | --- | | H 01 L |
| A | APPLIED PHYSICS LETTERS, vol. 35, no. 8, octobre 1979, pages 621-623, New York, USA M. KOYANAGI et al.: "Short-channel MOS FET's fabricated by self-aligned ion implantation and laser annealing" | | |
| | --- -/- | | |

Le présent rapport de recherche a été établi pour toutes les revendications

| Lieu de la recherche LA HAYE | Date d'achèvement de la recherche 12-10-1983 | Examinateur VANCRAEYNEST F.H. |
|---|---|---|

Office européen
des brevets

**RAPPORT DE RECHERCHE EUROPEENNE**

| | **DOCUMENTS CONSIDERES COMME PERTINENTS** | | **Page 2** | |
|---|---|---|---|---|
| Catégorie | Citation du document avec indication, en cas de besoin, des parties pertinentes | Revendication concernée | CLASSEMENT DE LA DEMANDE (Int. Cl. 3) | |
| A | IEEE ELECTRON DEVICES, vol. ED-27, no. 8, août 1980, pages 1559-1565, New York, USA R.F. MOTTA et al.: "Computer-aided device optimization for MOS/VLSI"<br><br>----- | | | |
| | | | **DOMAINES TECHNIQUES RECHERCHES (Int. Cl. 3)** | |

Le présent rapport de recherche a été établi pour toutes les revendications

| Lieu de la recherche<br>LA HAYE | Date d'achèvement de la recherche<br>12-10-1983 | Examinateur<br>VANCRAEYNEST F.H. |
|---|---|---|